# EUROPEAN PATENT APPLICATION

(11) **EP 1 818 988 A2**
(43) Date of publication of application: **15.08.2007**
(21) Application number: 07102130.7
(22) Date of filing: 12.02.2007
(51) Int. Cl.: H01L 25/065

(54) **Integrated circuit chip and package**

(30) Priority: 14.02.2006 KR 20060014268
(71) Applicant: Integrant Technologies Inc., Seongnam-si, Gyoenggi-do 463-810 (KR)
(72) Inventor: Tchun, Seok Phyo, Sangrok Apt. 706-105, Sinjeong Maeul, Yongin-si, Gyeonggi-do (KR); KIM, Kyung Oh, Seoul (KR); KIM, Bo-Eun, Yongin-si, Gyeonggi-do (KR)
(74) Representative: Kastel, Stefan

(57) **Abstract**

An integrated circuit chip and a package supported by a device or a semiconductor chip are provided. The integrated circuit chip comprises a substrate, a device part, and a first integrated circuit chip. The device part is formed over the substrate, and the first integrated circuit chip is formed over the device part. The area occupied by the integrated circuit chip can be reduced. This reduction in area allows miniaturization of devices, cost reduction, improvement in productivity, and minimization of an occurrence of electrical interference between integrated circuit chips. As a result, it is possible to prevent degradation of the performance.

## Description

This application claims priority on Patent Application No. 10-2006-0014268 filed in Republic of Korea on February 14, 2006, the entire contents of which are hereby incorporated by reference.

### BACKGROUND

### Field

This document relates to an integrated circuit (IC) chip and a package.

During fabrication of semiconductor chips, after completing numerous processes including etching and deposition applied in a wafer basis, the resultant devices are tested and packaged together. A typical packaging refers to a process of mounting semiconductor chips over a substrate where leads are formed and molding the mounted semiconductor chips using a synthetic molding material such as plastics.

A conventional packaging of more than 2 IC chips that are correlated with each other will be described in detail.

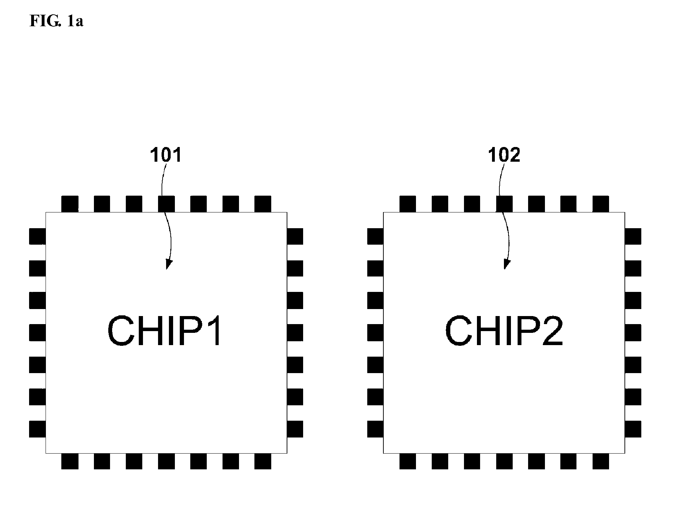

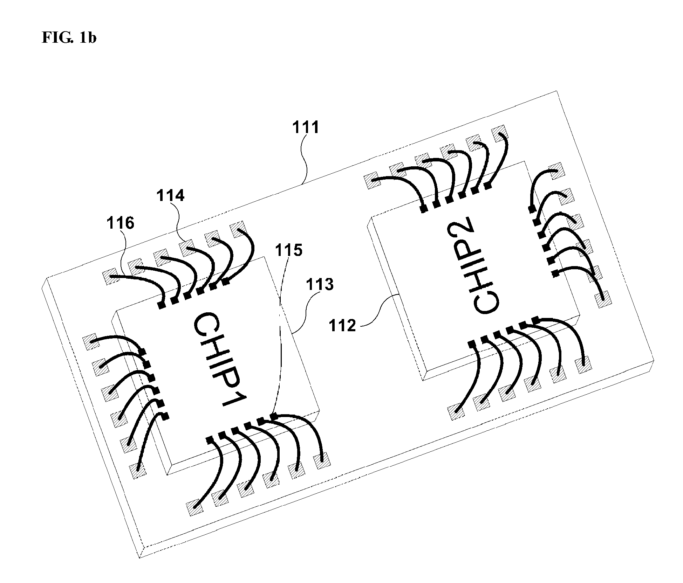

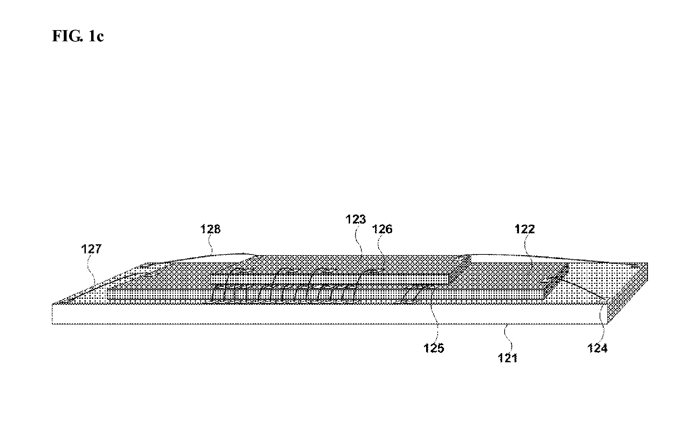

FIG. 1a illustrates two packaged IC chips. The two IC chips 101 and 102 are reciprocally connected to each other from the outside of the IC chips through a substrate or transmission lines (not shown). Since the two IC chips 101 and 102 or more are packaged individually, the total area of the device usually increases. Thus, as illustrated in FIG. 1 b, another packaging is developed to overcome the above limitation.

Particularly, FIG. 1b illustrates an exemplary package in which two IC chips 112 and 113 are individually connected to each other through wires on a substrate 111 by electrically bonding pads 115 of the two IC chips 112 and 113 to respective pads 114 of the substrate 111. Reference numeral 116 represents the electrical wire-bonding. Since the IC chips 112 and 113 each are disposed at the same plane of the substrate 111, the area occupied by the entire IC chip that is packaged is often maintained as same as the areas of the individual IC chips 112 and 113 before the packaging.

The packages illustrated in FIGS. 1a and 1b may be limited in the reduction of the areas occupied by the IC chips, and this limitation may lead to a difficulty in miniaturizing the volume of the entire device.

As illustrated in FIG. 1c, IC chips 122 and 123 are stacked over each other as another packaging in order to overcome the aforementioned difficulty.

In particular, FIG. 1c illustrates two conventional IC chips 122 and 123 that are bonded together in a stack type on a substrate 121 through respective wires 127 and 128. Pads 125 and 126 of the IC chips 122 and 123 are electrically connected with respective pads of the substrate 121. Although the areas occupied by the IC chips 122 and 123 inside the package can be reduced, since the two IC chips 122 and 123 stacked in an up-down direction are connected individually to the substrate 121, there may arise an electrical interference between signals reciprocally processed by the two conventional IC chips 122 and 123. Particularly, the electrical interference may become severe when the two IC chips 122 and 123 process different signals.

### SUMMARY

An aspect of this document is to provide to provide an integrated circuit (IC) chip and a package that can reduce the area of the package.

Another aspect of the present invention is to provide an IC circuit chip and a package that can minimize an electrical interference between IC chips.

In an aspect, an integrated circuit chip comprises a substrate, a device part formed over the substrate, and a first integrated circuit chip formed over the device part.

The device part may comprise at least two devices spaced apart from each other.

The device part may be one of an active device and a passive device.

The integrated circuit chip may further comprise one of a second integrated circuit chip and an additional device part, both formed over the substrate.

A height of the device part spaced apart from the substrate may be greater than a height of the second integrated circuit chip or the additional device part.

The substrate may be electrically coupled to the first integrated circuit chip through bonding wires.

The substrate may be electrically coupled to the second integrated circuit chip through bonding wires.

The substrate may be electrically coupled to the second integrated circuit chip through a mechanical contact based on a SMT (surface mount technology).

One of the first integrated circuit chip and the second integrated circuit chip may be a chip receiving a RF (radio frequency) signal, and the other of the first integrated circuit chip and the second integrated circuit chip may be a chip comprising a digital block where digital circuits are formed.

The integrated circuit chip may further comprise a third integrated circuit chip formed over the first integrated circuit chip.

The third integrated circuit chip may be electrically coupled to the substrate through bonding wires.

The third integrated circuit chip may be electrically coupled to the first integrated circuit chip through bonding wires.

The third integrated circuit chip may be a chip comprising a digital block wherein digital circuits are formed.

The integrated circuit chip may further comprise a fourth integrated circuit chip formed over the substrate, and the first integrated circuit chip may be formed over the device part and the fourth integrated circuit chip.

The substrate may be electrically coupled to the fourth integrated circuit chip through a mechanical contact based on a SMT.

In another aspect, an integrated circuit package comprising the integrated circuit chip according to the aspect of the present invention.

### BRIEF DESCRIPTION OF THE DRAWINGS

The implementation of this document will be described in detail with reference to the following drawings in which like numerals refer to like elements.

FIG. 1a illustrates two conventional integrated circuit (IC) chips that are individually packaged;

FIG. 1b illustrates another conventional packaging in which two IC chips are bonded together over one substrate through wires, wherein pads of the IC chips are electrically connected with respective pads of the substrate;

FIG. 1c illustrates another conventional packaging in which two conventional IC chips are bonded together in a stack type through wires, wherein pads of the IC chips are electrically connected with respective pads of the substrate;

FIG. 2 illustrates an IC chip according to a first embodiment of the present invention;

FIG. 3 illustrates an IC chip according to a second embodiment of the present invention;

FIG. 4 illustrates an IC chip according to a third embodiment of the present invention;

FIG. 5 illustrates an IC chip according to a fourth embodiment of the present invention;

FIG. 6 illustrates an IC chip according to a fifth embodiment of the present invention; and

FIG. 7 illustrates an IC chip according to a sixth embodiment of the present invention.

### DETAILED DESCRIPTION

Hereinafter, an implementation of this document will be described in detail with reference to the attached drawings.

In general, an electrical connection between a substrate and an IC chip can be classified into a wire-bonding method and a flip-chip-bonding method depending on packaging types. According to the wire-bonding method, a substrate where leads are formed is electrically coupled to a semiconductor chip using miniaturized wires. According to the flip-chip-bonding method, a substrate and a semiconductor chip are coupled to each other through junction points of projection units such as bumps or solder balls of the semiconductor chip and the substrate. Particularly, when a semiconductor chip and a substrate are coupled together, the flip-chip-bonding method can give a more space than the wire-bonding method, and thus, allowing the miniaturization in packaging. The flip-chip-bonding method is one of surface mounting technologies. More specifically, when electrical parts are bonded to a substrate, the electrical parts are bonded to a bonding pattern, formed on the surface of the substrate, not through openings of the electrical parts but through soldering. On the basis of this technology, parts can be miniaturized, and lead pins can be fabricated in narrow chips, and thus, this technology further allows the realization of high density mounting of desired products on a target.

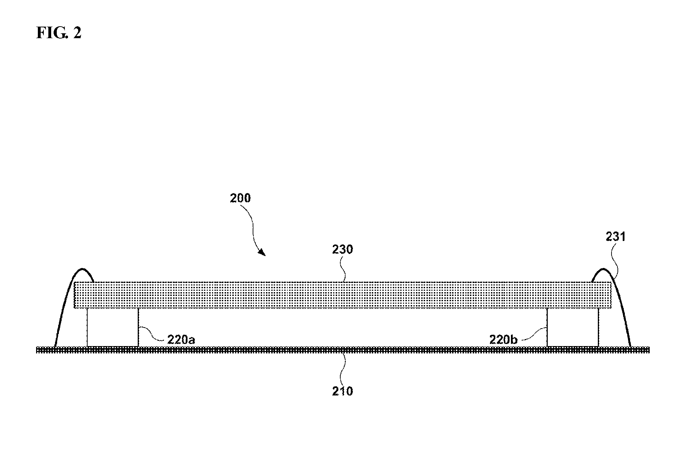

FIG. 2 illustrates an integrated circuit (IC) chip 200 according to a first embodiment of the present invention.

As illustrated, the IC chip 200 comprises a substrate 210, a device part, and a first IC chip 230.

The device part comprises an active device or a passive device. The passive device may be a resistor, a capacitor, or an inductor. The device part comprises first and second devices 220a and 220b, which are spaced apart from each other.

The substrate 210 is a circuit substrate in which signals are electrically coupled to each other. For instance, the substrate 210 may be one of a ball grid array (BGA), a land grid array (LGA), a printed circuit board (PCB), and a low temperature co-fired ceramics (LTCC). Using a surface mounting technology (SMT), the first and second devices 220a and 220b are formed to be electrically coupled to the upper surface of the substrate 210 through a mechanical contact.

The first IC chip 230 is formed over the first and second devices 220a and 220b by using the first and second devices 220a and 220b as a post. An adhesive material is further formed over the upper surface of the first and second devices 220a and 220b. The first IC chip 230 is adhered and affixed to the upper surface of the first and second devices 220a and 220b through the adhesive material.

The first IC chip 230 is electrically coupled to the substrate 210 through bonding wires 231.

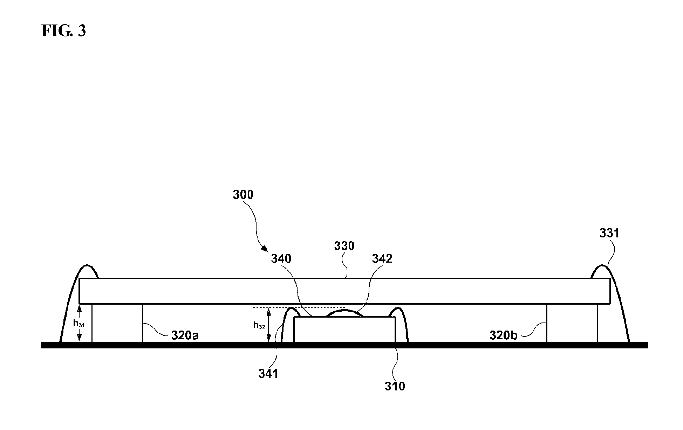

FIG. 3 illustrates an IC chip 300 according to a second embodiment of the present invention.

According to the second embodiment, the IC chip 300 comprises a substrate 310, a device part, a first IC chip 330, and a second IC chip 340. The IC chip 300 illustrated in FIG. 3 is substantially the same as the IC chip 200 illustrated in FIG. 2, but has one difference from the IC chip 200 in that the IC chip 300 further comprises the second IC chip 340. Thus, detailed description of the same elements will be replaced with that provided in FIG. 2. Hereinafter, the second IC chip 340 will be described in detail.

The device part comprises a first device 320a and a second device 320b, which are spaced apart from each other.

The first IC chip 330 is electrically coupled to the substrate 310 through first bonding wires 331. The second IC chip 340 is formed in the space between the first device 320a and the second device 320b and over the substrate 310.

A wire-inductor 342 may be formed on the upper surface of the second IC chip 340, and is electrically coupled to the substrate 310 through second bonding wires 341. The second IC chip 340 may be formed in more than one IC chip.

A height h31 at which the first IC chip 330 spaced apart from the substrate 310 is greater than a height h32 at which the wire-inductor 342 of the second IC chip 340, which is formed over the substrate 310, is formed. More specifically, the height h31 of the first and second devices 320a and 320b, which are formed over the substrate 310, is greater than the height h32 defined by the wire-inductor 342 of the second IC chip 340.

One of the first IC chip 330 and the second IC chip 340 is a chip that receives a radio frequency (RF) signal, and the other of the first IC chip 330 and the second IC chip 340 is a chip that comprises a digital block where digital circuits are formed.

Assuming that the second IC chip 340 is the RF receiving chip and the first IC chip 330 is the chip that comprises the digital block where the digital circuits are formed, because the first IC chip 330 shields external noise, degradation of the performance, which is often caused by external noise, can be reduced, and a signal interference occurring when processing different signals can be reduced.

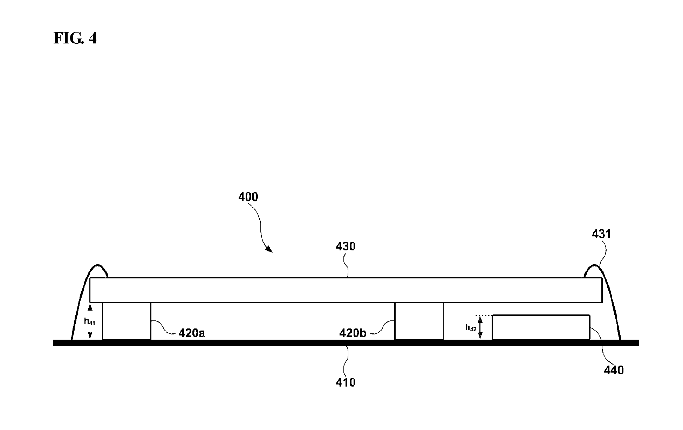

FIG. 4 illustrates a stack type IC chip 400 according to a third embodiment of the present invention. The stack type IC chip 400 comprises a substrate 410, a device part, a first IC chip 430, and a second IC chip 440. The device part comprises a first device 420a and a second device 420b, which are spaced apart from each other. The stack type IC chip 400 is different from the IC chip 300 illustrated in FIG. 3 in that the second device 420b and the second IC chip 440 are disposed differently from the second device 320b and the second IC chip 340, and the substrate 410 and the second IC chip 440 are coupled differently from the substrate 310 and the second IC chip 340. These differences will be described in detail.

The first IC chip 430 is electrically coupled to the substrate 410 through bonding wires 431. The second IC chip 440 is formed between the first IC chip 430 and the substrate 410, and is electrically coupled to the substrate 410 through a mechanical contact based on the SMT. The second IC chip 440 may be formed in more than one IC chip.

A height h41 at which the first IC chip 430 is spaced apart from the substrate 410 is greater than a height h42 of the second IC chip 440 formed over the substrate 410. Therefore, the height h41 of the first and second devices 420a and 420b formed over the substrate 410 is greater than the height h42 of the second IC chip 440.

One of the first IC chip 430 and the second IC chip 440 is a chip that receives a RF signal, and the other of the first IC chip 430 and the second IC chip 440 is a chip that comprises a digital block where digital circuits are formed.

Assuming that the second IC chip 440 is the RF receiving chip, and the first IC chip 430 is the chip that comprises the digital block, because the first IC chip shields external noise, degradation of the performance can be reduced, and a signal interference, which often occurs when processing different signals, can also be reduced. In addition, since the first IC chip 430 and the second IC chip 440 each are coupled to the substrate 410 in a different manner, the signal interference can be further reduced. In other words, according to the third embodiment of the present invention, an occurrence of the signal interference can be further reduced since the first IC chip 430 is coupled to the substrate 410 through wire bonding, while the second IC chip 440 is coupled to the substrate 410.

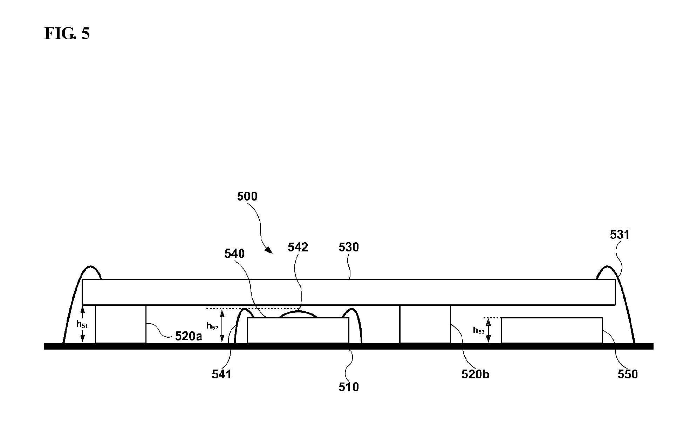

FIG. 5 illustrates an IC chip 500 according to a fourth embodiment of the present invention. The IC chip 500 comprises a substrate 510, a device part, a first IC chip 530, a second IC chip 540, and a third IC chip 550. The device part comprises a first device 520a and a second device 520b, which are spaced apart from each other. The IC chip 500 illustrated in FIG. 5 is obtained by combining the IC chip 400 illustrated in FIG. 4 and the IC chip 300 illustrated in FIG. 3, and will be described in detail hereinafter.

The first IC chip 530 is electrically coupled to the substrate 510 through first boding wires 531. The second IC chip 540 is formed in the space between the first device 520a and the second device 520b and over the substrate 510. The third IC chip 550 is formed between the first IC chip 530 and the substrate 510.

A wire-inductor 542 may be formed on the upper surface of the second IC chip 540, and the second IC chip 540 is electrically coupled to the substrate 510 through second bonding wires 541. The second IC chip 540 may be formed in more than one IC chip.

The third IC chip 550 is electrically coupled to the substrate 510 through a mechanical contact based on the SMT. The third IC chip 550 may be formed in more than one IC chip.

A height h51 at which the first IC chip 530 is spaced apart from the substrate 510 is greater than a height h52 defined by the wire-inductor 542 of the second IC chip 540 or the second bonding wires 541, and a height h53 of the third IC chip 550.

One of the first IC chip 530, the second IC chip 540, and the third IC chip 550 is a chip that receives a RF signal, and one of the rest IC chips 530, 540, and 550 is a chip that comprises a digital block where digital circuits are formed.

Assuming that the second IC chip 540 or the third IC chip 550 is the RF receiving chip, and the first IC chip 530 is the chip that comprises the digital block, because the first IC chip 530 shields external noise, degradation of the performance, which is often caused by external noise, can be reduced, and a signal interference occurring when processing different signals can also be reduced. In addition, the first, second and third IC chips 530, 540, and 550 are coupled to the substrate 510 differently from each other, and thus, the signal interference can be reduced to a further extent.

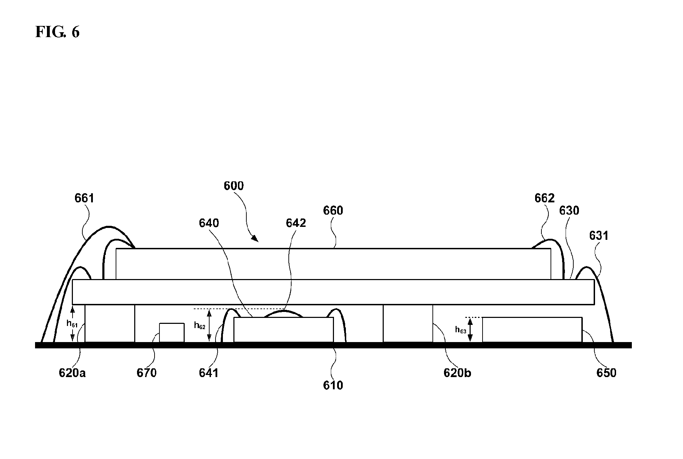

FIG. 6 illustrates an IC chip 600 according to a fifth embodiment of the present invention. The IC chip 600 comprises a substrate 610, a device part, an additional device part 670, a first IC chip 630, a second IC chip 640, a third IC chip 650, and a fourth IC chip 660. The device part comprises a first device 620a and a second device 620b, which are spaced apart from each other. The IC chip 600 illustrated in FIG. 6 is different from the IC chip 500 illustrated in FIG. 5 in that the IC chip 600 further comprises the additional device part 670 and the fourth IC chip 660. The additional device part 670 and the fouth IC chip 660 will be described in detail.

The fourth IC chip 660 is stacked over the first IC chip 630. The fourth IC chip 660 is electrically coupled to the substrate 610 through third bonding wires 661. According to the circuit configuration, the fourth IC chip 660 is electrically coupled to the first IC chip 630 through fourth bonding wires 662. The fourth IC chip 660 may be formed in more than one IC chip.

The additional device part 670 is formed in the space between the first device 620a and the second device 620b and over the substrate 610, and is electrically coupled to the substrate 610 through a mechanical contact based on the SMT. The additional device part 670 may be formed in more than one passive device.

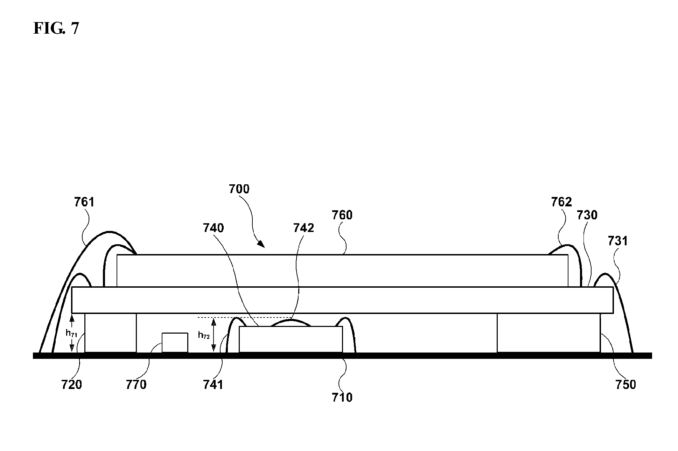

FIG. 7 illustrates an IC chip 700 according to a sixth embodiment of the present invention. The IC chip 700 comprises a substrate 710, a device part 720, an additional device part 770, a first IC chip 730, a second IC chip 740, a third IC chip 750, and a fourth IC chip 760. The device part 720 comprises an active device or a passive device, which comprises a resistor, a capacitor or an inductor.

The substrate 710 is a circuit substrate in which signals are electrically coupled to each other. For instance, the substrate 710 may be one of a BGA, an LGA, a PCB, and an LTCC. Using the SMT, the device part 720 and the third IC chip 750 each are formed to be electrically coupled to the upper surface of the substrate 710 through a mechanical contact.

The first IC chip 730 is formed over the device part 720 and the third IC chip 750 by using the device part 720 and the third IC chip 750 as a post. The first IC chip 730 is electrically coupled to the substrate through first bonding wires 731.

The second IC chip 740 is formed in the space between the device part 720 and the third IC chip 750 and over the substrate 710. The third IC chip 750 is formed between the first IC chip 730 and the substrate 710. An adhesive material is further formed over the upper surface of the device part 720 and the third IC chip 750. The first IC chip 730 is adhered and affixed to the upper surface of the device part 720 and the third IC chip 750 through the adhesive material. A wire-inductor 742 may be formed on the upper surface of the second IC chip 740. The second IC chip 740 is electrically coupled to the substrate 710 through second bonding wires 741. The second IC chip 740 may be formed in more than one IC chip.

The additional device part 770 is formed in the space between the device part 720 and the third IC chip 750, and over the substrate 710, and is electrically coupled to the substrate 710 through a mechanical contact based on the SMT. The additional device part 770 may be formed in more than one passive device.

The third IC chip 750 is formed to be electrically coupled to the substrate 710 through a mechanical contact based on the SMT. The third IC chip 750 may be formed in more than one IC chip.

A height h71 at which the first IC chip 730 is spaced apart from the substrate 710 is greater than a height h72 defined by the wire-inductor 742 of the second IC chip 740, which is formed over the substrate 710, or by the second bonding wires 741.

The fourth IC chip 760 is stacked over the first IC chip 730. The fourth IC chip 760 is electrically coupled to the substrate 710 through third bonding wires 761. According to the circuit configuration, the fourth IC chip 760 is electrically coupled to the first IC chip 730 through fourth bonding wires 762. The fourth IC chip 760 may be formed in more than one IC chip.

One of the first IC chip 730, the second IC chip 740, the third IC chip 750, and the fourth IC chip 760 is a chip that receives a RF signal, and one of the rest IC chips 730, 740, 750, and 760 is a chip that comprises a digital block where digital circuits are formed.

Assuming that the second IC chip 740 or the third IC chip 750 is the RF receiving chip and the first IC chip 730 is the chip that comprises the digital block, because the first IC chip 730 shields external noise, the IC chip 700 is resistant to external noise. Also, an electrical interference between the first, second, third, and fourth IC chips 730, 740, 750, and 760 can be minimized, so as to prevent degradation of the performance.

According to various embodiments of the present invention, the area occupied by the IC chip can be reduced, thereby contributing to the miniaturization of devices, and the cost reduction, which allows an improvement in productivity.

Also, an occurrence of electrical interference between the IC chips can be minimized, thereby reducing degradation of the performance.

## Claims

1. An integrated circuit chip comprising:
a substrate;
a device part formed over the substrate; and
a first integrated circuit chip formed over the device part.

2. The integrated circuit chip of claim 1, wherein the device part comprises at least two devices spaced apart from each other.

3. The integrated circuit chip of claims 1 or 2, wherein the device part is one of an active device and a passive device.

4. The integrated circuit chip of any of the claims 1 to 3, further comprising one of a second integrated circuit chip and an additional device part, both formed over the substrate.

5. The integrated circuit chip of claim 4, wherein a height of the device part spaced apart from the substrate is greater than a height of the second integrated circuit chip or the additional device part.

6. The integrated circuit chip of any of the claims 1 to 4, wherein the substrate is electrically coupled to the first integrated circuit chip through bonding wires.

7. The integrated circuit chip of any of the claims 4 to 6, wherein the substrate is electrically coupled to the second integrated circuit chip through bonding wires.

8. The integrated circuit chip of any of the claims 4 to 7, wherein the substrate is electrically coupled to the second integrated circuit chip through a mechanical contact based on a SMT (surface mount technology).

9. The integrated circuit chip of any of the claims 4 to 8, wherein one of the first integrated circuit chip and the second integrated circuit chip is a chip receiving a RF (radio frequency) signal, and the other of the first integrated circuit chip and the second integrated circuit chip is a chip comprising a digital block where digital circuits are formed.

10. The integrated circuit chip of any of the claims 1 to 9, further comprising a third integrated circuit chip formed over the first integrated circuit chip.

11. The integrated circuit chip of claim 10, wherein the third integrated circuit chip is electrically coupled to the substrate through bonding wires.

12. The integrated circuit chip of claim 10 or 11, wherein the third integrated circuit chip is electrically coupled to the first integrated circuit chip through bonding wires.

13. The integrated circuit chip of any of the claims 10 to 12, wherein the third integrated circuit chip is a chip comprising a digital block wherein digital circuits are formed.

14. The integrated circuit chip of any of the claims 1 to 13, further comprising a fourth integrated circuit chip formed over the substrate, wherein the first integrated circuit chip is formed over the device part and the fourth integrated circuit chip.

15. The integrated circuit chip of claim 14, wherein the substrate is electrically coupled to the fourth integrated circuit chip through a mechanical contact based on a SMT (surface mounting technology).

16. An integrated circuit package comprising the integrated circuit chip according to any of the claims 1 to 15.
